(19) Europäisches Patentamt
European Patent Office
Office européen des brevets

(11) **EP 1 915 435 B1**

(12) # FASCICULE DE BREVET EUROPEEN

(45) Date de publication et mention de la délivrance du brevet:
**18.11.2009 Bulletin 2009/47**

(21) Numéro de dépôt: **06792850.7**

(22) Date de dépôt: **16.08.2006**

(51) Int Cl.:
***C09D 183/04*** *(2006.01)* ***H01L 21/312*** *(2006.01)*

(86) Numéro de dépôt international:
**PCT/EP2006/065370**

(87) Numéro de publication internationale:
**WO 2007/020273 (22.02.2007 Gazette 2007/08)**

(54) **REVETEMENT SILICONE DE FAIBLE CONSTANTE DIELECTRIQUE, PROCEDE DE PREPARATION ET APPLICATION AUX CIRCUITS INTEGRES**

SILIZIUMBESCHICHTUNG MIT NIEDRIGER DIELEKTRIZITÄTSKONSTANTE, HERSTELLUNGSVERFAHREN DAFÜR UND DEREN ANWENDUNG FÜR INTEGRIERTE SCHALTUNGEN

LOW DIELECTRIC CONSTANT SILICON COATING, METHOD FOR THE PREPARATION AND APPLICATION THEREOF TO INTEGRATED CIRCUITS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **19.08.2005 FR 0508637**

(43) Date de publication de la demande:
**30.04.2008 Bulletin 2008/18**

(73) Titulaire: **Bluestar Silicones France SAS**
**69003 Lyon (FR)**

(72) Inventeurs:
- **GIRAUD, Yves**
  **F-69110 Sainte Foy les Lyon (FR)**
- **VERGELATTI, Caroll**
  **F-38118 Sainte Baudille de la Tour (FR)**
- **TUPINIER, Didier**
  **F-93120 La Courneuve (FR)**
- **ODONI, Ludovic**
  **F-69140 Rillieux la Pape (FR)**
- **BASIRE, Charlotte**
  **F-69970 Marennes (FR)**
- **TROUILLET, Lise**
  **F-69003 Lyon (FR)**

(74) Mandataire: **Cabinet Plasseraud**
**52, rue de la Victoire**
**75440 Paris Cedex 09 (FR)**

(56) Documents cités:
**US-A- 6 022 814** **US-B1- 6 313 045**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 1 915 435 B1

## Description

### DOMAINE DE L'INVENTION

L'invention se rapporte au domaine des matériaux d'interconnexion notamment pour la fabrication de circuits intégrés par lithographie optique. Plus particulièrement, l'invention concerne un revêtement silicone présentant une faible constante diélectrique, ainsi qu'un procédé de préparation d'un tel revêtement.

### CONTEXTE DE L'INVENTION

La recherche de circuits intégrés rapides et compacts nécessite le développement de transistors de dimensions réduites.

En tant qu'élément constitutif de première importance dans un circuit intégré, l'interconnexion gère l'ensemble des échanges et informations entre les transistors et les autres microcomposants au sein du circuit intégré. L'interconnexion est un ensemble complexe de couches déposées puis gravées qui obéissent à certaines règles d'alternance entre :

- des lignes métalliques conductrices ou lignes de courant, réalisées en aluminium Al pour les anciennes générations de microprocesseurs, qui véhiculent le signal électrique dans le circuit, et
- des couches isolantes entre lignes de courant, constituées de silice $SiO_2$ qui, en séparant les lignes métalliques conductrices, limitent la diffusion d'espèces métalliques et contribuent ainsi à la stabilité du signal.

Les performances techniques du couple A1 / SiO2 ont su parfaitement répondre à l'évolution des technologies de miniaturisation sur plusieurs générations de puces et microcomposants, jusqu'à ce que l'émergence de la génération 180 nm contribue à identifier un verrou technique majeur.

Plus les transistors incorporés au circuit intégré sont petits, plus la vitesse de commutation entre transistors est grande. En d'autres termes, le délai de commutation ("Gate Delay" - GD) diminue. Parallèlement, la longueur totale des connexions électriques augmente, de sorte que le délai d'interconnexion ("Interconnect Delay - ID) augmente.

Dans l'association $Al/SiO_2$, pour des générations de dimensions supérieures -donc des générations plus anciennes- à 180 nm, c'est la vitesse de commutation qui limite les gains de vitesse des microprocesseurs. Par contre, dans les générations de dimensions inférieures à 180 nm -plus récentes- la vitesse d'interconnexion devient un facteur limitant par rapport à la vitesse de commutation entre transistors.

Ce phénomène entraîne des risques potentiels de dissipation de puissance, de distorsion du signal, de transfert partiel d'énergie de ligne à ligne (diaphonie), bref de diminution globale des performances du circuit.

Pour mémoire, dans le domaine des semi-conducteurs, la valeur qui désigne une génération de puces (par exemple 180 nm) reflète le demi pas de l'interconnexion, c'est-à-dire la demie somme entre l'épaisseur moyenne de la couche isolante et l'épaisseur moyenne de la ligne métallique associée.

Pour contourner ce verrou technique, une première proposition a consisté à remplacer progressivement l'aluminium des lignes métalliques conductrices (résistivité $R_{Al}$ = 3,1 Ω.cm) par un métal dont la résistivité est plus faible, tel que le cuivre (résistivité $R_{Cu}$ = 1,7 Ω.cm).

La seconde proposition concernait les couches isolantes entre lignes de courant. Il a été suggéré de remplacer la silice (constante diélectrique relative $K_{SiO2}$ = 4,1) par des matériaux à faible constante diélectrique, *i.e.* dont la constante diélectrique devrait être inférieure à 3,0 pour les besoins des générations futures d'interconnexions. En effet, le délai d'interconnexion d'un circuit est corrélé à la capacitance du circuit, elle-même liée à la constante diélectrique des couches isolantes.

### ART ANTERIEUR

Obtenir des matériaux d'interconnexion possédant une faible constante diélectrique implique de réduire la densité de liaisons chimiques au sein du matériau, soit en diminuant la densité du matériau, soit en rendant le matériau poreux.

De nombreux matériaux diélectriques poreux ont été proposés dans ce domaine. Le choix s'est porté essentiellement sur des matériaux à porosité fermée, d'une part, pour éviter le risque de migration d'espèces métalliques à travers les couches isolantes, et d'autre part, pour des raison de tenue mécanique. De nombreuses voix d'accès à une porosité fermée ont été développées récemment. Parmi celles-ci, on peut citer :

Le brevet US-B-6,214,748 concerne une méthode pour former un film fin sur un substrat. Ce film est produit en appliquant une solution comprenant une résine réticulable à chaud, isolante électrique, et un mélange de solvant dont l'un présente un haut point d'ébullition. Le premier solvant, majoritaire, est éliminé par séchage classique du

dépôt, à une température de 100 à 120°C. Le second solvant, minoritaire, se volatilise lors du traitement à haute température supérieure à 300°C. Cette volatilisation du solvant minoritaire génère une porosité dans l'épaisseur de la couche.

Le brevet US-B-6,107,357 concerne la fabrication d'un matériaux diélectrique à partir d'une composition préparée en greffant sur une résine silicone un motif organique porogène à haute température, par l'intermédiaire d'un agent de couplage. Après avoir formé un film à partir de cette composition, il est soumis à une haute température, afin de décomposer le porogène.

Le brevet US-A-6,022,814 concerne un matériau diélectrique poreux généré à partir d'un mélange de résines silicones porteuses de groupements thermiquement labiles. Un film de ce matériau est formé en déposant une couche du mélange, puis en chauffant afin d'éliminer les groupes thermiquement labiles et de générer la porosité.

Le brevet US-A-5,776,990 concerne un matériau diélectrique poreux fabriqué à partir d'un copolymère entre une matrice polymère et un polymère décomposable thermiquement à une température inférieure à la température de dégradation de la matrice polymère. Le copolymère est séquencé, de sorte qu'il forme des micro-phases séparées les unes des autres. Sous l'effet de la chaleur, la partie décomposable thermiquement est éliminée.

La demande de brevet américain US-A-2001/0010840 concerne une composition à base d'une résine silicone. Cette composition comprend une résine isolante électrique porteuse d'atomes d'hydrogène liés à un atome de silicium, un composé porteur de groupes susceptibles de réagir avec des atomes d'hydrogène liés à un atome de silicium de la résine et dont le point d'ébullition sous pression atmosphérique est supérieur à 250°C. La composition comprend en outre un solvant. Le revêtement est formé en déposant une couche de la composition sur un support, puis en la portant à haute température ou en la soumettant à une radiation à haute énergie. Cela provoque une réticulation de la résine et du composé susceptible de réagir avec les atomes d'hydrogène liés au silicium de la résine, ainsi que l'évaporation du solvant.

La demande de brevet américain US-A-2003/0207595 concerne la fabrication d'un matériau à faible constante diélectrique pour semi-conducteur. Ce matériau est obtenu à partir d'un mélange hybride entre une résine silicone et un polymère organique "sacrificiel" amphiphile, en l'occurrence un copolymère séquencé. L'un des blocs du copolymère est miscible avec la résine silicone, tandis que l'autre bloc du copolymère ne l'est pas. Ainsi, la composante non miscible du copolymère amorce une micro-séparation de phases avec la résine silicone, tandis que l'autre composante du copolymère, permet de limiter cette micro-séparation. La phase non miscible est éliminée lors d'une étape de chauffage à haute température, afin d'engendrer la porosité recherchée.

## OBJECTIF DE L'INVENTION

Un objectif de la présente invention est de proposer un procédé de préparation d'un revêtement à faible constante diélectrique, pour des applications dans le domaine des circuits intégrés. Par faible constante diélectrique, on désigne notamment les matériaux dont la constante diélectrique relative est inférieure ou égale à 3.

Un autre objectif de l'invention est de proposer un procédé de préparation d'un revêtement à faible constante diélectrique en film mince, compatible avec le développement de semi-conducteurs de la génération 180 nm et de génération ultérieure.

Encore un objectif de l'invention est de proposer un procédé de préparation d'un revêtement à faible constante diélectrique adaptable aux procédés de fabrication en grande série connus à ce jour.

Un objectif de l'invention est également de proposer un procédé de préparation d'un revêtement à faible constante diélectrique, thermiquement stable à haute température.

Un objectif supplémentaire de l'invention est de proposer un procédé de préparation d'un revêtement à faible constante diélectrique facilement mis en oeuvre et d'un coût maîtrisé.

Encore un objectif de l'invention est de proposer un procédé de préparation d'un revêtement silicone nanoporeux, à faible constante diélectrique, et mieux encore grâce auquel on peut contrôler la dimension des pores.

Un objectif supplémentaire de l'invention est de proposer un procédé de préparation d'un revêtement silicone à faible constante diélectrique, mettant en oeuvre des produits aisément disponibles.

Encore un objectif de l'invention est de fournir un nouveau matériau d'interconnexion, utile pour le développement des nouvelles générations de circuit intégré, notamment des générations 180 nm et inférieure, notamment 60 nm.

D'autres objectifs et avantages de la présente invention apparaîtront à la lecture de la description qui va suivre.

## BREVE DESCRIPTION DE L'INVENTION

Il est du mérite des inventeurs d'avoir développé un nouveau procédé de préparation d'un revêtement silicone à faible constante diélectrique, procédé qui permet d'atteindre les objectifs précédemment évoqués parmi d'autres. Ce procédé comprend les étapes essentielles suivantes :

a) on dépose une composition silicone filmogène sur la surface d'un support, ladite composition silicone comprenant : (i) au moins une résine silicone filmogène réticulable, (ii) au moins une huile silicone essentiellement linéaire, α,ω-hydroxylée, susceptible de se dégrader à chaud, et (iii) au moins un solvant apte à compatibiliser la résine silicone (i) et l'huile silicone (ii),
b) on élimine le solvant (iii), de préférence par chauffage et, de façon simultanée ou séquentielle,
c) on chauffe pour réaliser la cuisson de la composition silicone filmogène.

L'invention concerne également un revêtement silicone susceptible d'être obtenu à l'issu d'un tel procédé de préparation, ainsi qu'un circuit intégré comprenant un tel revêtement silicone, comme isolant électrique.

En outre, l'invention concerne l'utilisation d'une composition silicone comprenant : (i) au moins une résine silicone filmogène réticulable, (ii) au moins une huile silicone essentiellement linéaire, α,ω-hydroxylée, susceptible de se dégrader à chaud, et (iii) au moins un solvant apte à compatibiliser la résine silicone (i) et l'huile silicone (ii), pour la préparation d'un revêtement à faible constante diélectrique, notamment dans un circuit intégré.

## DESCRIPTION DETAILLEE DE L'INVENTION

Dans la suite de la présente demande, on décrira de façon conventionnelle les huiles et les résines silicones à l'aide des notations usuelles suivantes, utilisées pour désigner divers motifs siloxy :

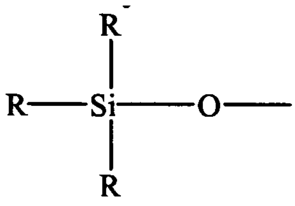

$M = (R)_3SiO_{1/2}$

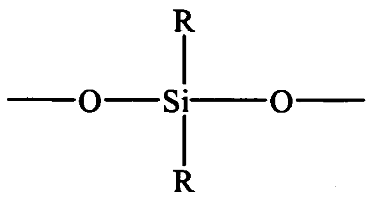

$D = (R)_2SiO_{2/2}$

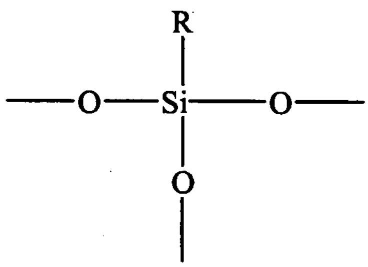

$T = (R)SiO_{3/2}$

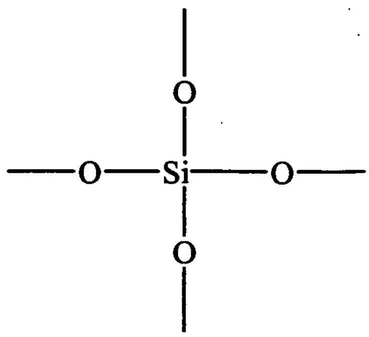

$Q = SiO_{4/2}$

Dans ces motifs, R peut représenter divers groupes hydrocarbonés saturés ou insaturés, notamment aromatiques, et éventuellement substitués par des hétéro-atomes, ainsi que des groupements non-hydrocarbonés notamment. La signification de R sera indiquée dans la description.

Conventionnellement, dans cette notation, les atomes d'oxygène sont partagés entre deux atomes de silicium. Conventionnellement, on indique un groupe R particulier en le citant en exposant après le symbole M, D ou T. Par exemple $M^{OH}$ représente un motif M où un groupe R est une groupe hydroxyle -OH. De façon similaire, $D^{Phe2}$ représente un motif D dont les deux groupes R sont des groupes phényles (abrégé Phe) $-C_6H_5$. $T^{Me}$ représente un motif T dont le groupe R est un groupe méthyle (abrégé Me) $-CH_3$.

L'invention concerne en premier lieu un procédé de préparation d'un revêtement silicone à faible constante diélectrique. En gardant pour objectif le développement d'une porosité permettant une réduction effective de la constante diélectrique du matériau initial, tout en disposant de caractéristiques mécaniques suffisante, les inventeurs ont exploité une propriété de certaines huiles silicones, jusque là considérée comme un inconvénient. Il s'agit de la réversion à haute

température des huiles silicones essentiellement linéaire hydroxylées en cycles comportant généralement 4 à 5 motifs siloxyles.

Par "essentiellement linéaire", il faut comprendre une huile silicone portant moins de 2% molaire de motif T, de préférence moins de 1,5% molaire et mieux encore, moins de 1% molaire.

Brièvement, le procédé consiste essentiellement à solubiliser dans un solvant une résine silicone, de préférence porteuse de groupements méthyles et phényles, ainsi qu'une huile silicone, de préférence polydiméthylsiloxane (PDMS) à extrémités, $\alpha,\omega$-hydroxylée. Cette composition silicone filmogène est déposée sur un support, par une technique connue en soi de spin-coating (méthode dite de la "tournette"), puis on élimine le solvant, à chaud. Lors de cette étape de séchage ("baking"), on observe une démixtion de phases entre la résine silicone et l'huile silicone. Cette démixtion est probablement limitée par la gélification, puis la réticulation de la résine. Finalement, on traite à très haute température le revêtement ("curing"). Ce traitement provoque la réticulation du film par condensation des groupements -OH résiduel de la résine silicone. De plus, la porosité est générée à l'intérieur de la couche par dégradation thermique de l'huile silicone "sacrificielle". L'huile silicone se convertit de façon quasi spontanée d'une structure essentiellement linéaire en structure cyclique volatile. En s'évaporant, ces composés cycliques laissent place à des pores répartis dans l'épaisseur du film de résine silicone.

La ou les résine(s) filmogène(s) réticulable(s) (i) (on utilisera le singulier) est une résine organosilicone préparée par co-hydrolyse et co-condensation de chlorosilanes choisis dans le groupe $(R)_3SiCl$, $(R)_2SiCl_2$, $(R)SiCl_3$, $SiCl_4$. Ces résines sont des oligomères ou des polymères organopolysiloxanes ramifiés bien connus et disponibles dans le commerce. Elles présentent, dans leur structure, au moins deux motifs siloxyles différents choisis parmi les motifs M, D, T et Q définis ci-dessus, dont au moins un motif T ou un motif Q. Les radicaux R sont répartis de telle sorte que les résines comportent environ 0,8 à 1,8 radicaux R par atome de silicium.

Les radicaux R sont identiques ou différents entre eux. Ils sont choisis parmi les radicaux alkyles linéaires ou ramifiés en C1 à C6, les radicaux alcényles linéaires ou ramifiés en C2 à C4, les radicaux aryles et aralkyles en C6 à C10, les radicaux R étant éventuellement halogénés (de préférence fluorés). On peut citer tout particulièrement comme radicaux alkyles R, les radicaux méthyle, éthyle, isopropyle, tertiobutyle, n-hexyle et le radical trifluoro-3,3,3-propyle ; comme radicaux alcényles, les radicaux vinyle, allyle, propényle, butényle, butadiényle ; comme radicaux aryles et aralkyles, les radicaux phényle, benzyle, styryle, phénéthyle, cuményle, mésityle, tolyle et xylyle. En tout état de cause, au moins un radical R par molécule représente un radical aryle ou aralkyle, de préférence un radical phényle ou benzyle.

De plus ces résines ne sont pas complètement condensées : elles possèdent encore environ 0,001 à 1,5 groupes hydroxyle -OH et/ou alkoxyle $-OR^1$ par atome de silicium. Les radicaux $R^1$ sont identiques ou différents entre eux et sont choisis parmi les radicaux alkyles linéaires ou ramifiés en C1 à C6, et ont le même définition que les radicaux alkyles R. De préférence, les groupes alkoxyles $-OR^1$ sont sélectionnés parmi les groupes méthoxy, éthoxy, butoxy, isopropoxy, isobutoxy, *sec*-butoxy, *tert*-butoxy et leurs mélanges.

Comme exemples d'oligomères ou de polymères organopolysiloxanes ramifiés, on peut citer les résines MQ, les résines MDQ, les résines TD, les résines MDT et les résines MDTQ. Les groupes OH et/ou $OR^1$ peuvent être portées par les motifs M, D et/ou T. La teneur pondérale en groupes OH et/ou $OR^1$ est comprise entre 0,2 et 10 % en poids rapporté au poids de résine.

On préfère plus particulièrement comme radical alkyle R, le radical méthyle. On préfère plus particulièrement comme radical aryle R, le radical phényle. On préfère plus particulièrement comme radical alkyle $R^1$, les radicaux méthyle et éthyle.

Selon une variante préférée, au moins l'un des radicaux R par molécule représente un radical phényle. De préférence, le radical phényle est porté par un motif D (motif $D^{Phe}$) et/ou par un motif T (motif $T^{Phe}$). Ainsi, selon l'invention, la résine silicone (i) comporte avantageusement au moins deux des motifs $D^{Phe}$, T et $T^{Phe}$. La résine silicone (i) peut également comporter des motifs $D^{Phe2}$.

Selon une autre caractéristique, la résine silicone (i) comporte au moins trois groupes hydroxyles -OH et/ou $-OR^1$ par molécule, chacun d'entre eux étant lié à un atome de silicium, de préférence au moins trois groupes hydroxyles -OH. Avantageusement, la teneur pondérale en groupes hydroxyles -OH de la résine silicone (i) est inférieure à 2% en poids.

En ce qui concerne l'huile silicone (ii), il s'agit de préférence d'une huile polydiorganoxyloxane essentiellement linéaire, $\alpha,\omega$-hydroxylée. Avantageusement, il s'agit d'une huile polydiméthylesiloxane essentiellement linéaire de formule générale $M^{OH}-(D^{Me2})_n-M^{OH}$, où n varie de 1 à 20.

Comme cela a été mentionné ci-dessus, l'huile silicone peut comprendre des motifs T, en particulier $T^{Me}$, de préférence moins de 2% molaire.

L'huile silicone (ii) est susceptible de se dégrader à température élevée, pour former des composés cycliques comportant généralement de 3 à 10 motifs D dialkylsiloxyle, et le plus souvent 4, 5 ou 6 motifs D. Cette réversion intervient dès des températures de 150 à 160°C.

Le troisième composant essentiel de la composition silicone filmogène est un solvant (iii), ou un mélange de solvants, apte à compatibiliser la résine silicone (i) et l'huile silicone (ii). Il s'agit de préférence d'un solvant organique.

Il n'existe pas de restriction particulière sur la nature du solvant, pour autant qu'il favorise le mélange de la résine silicone (i) et de l'huile silicone (ii), sans réagir avec celle-ci. Comme exemple de solvant, on peut citer des solvants aromatiques tels que le toluène ou le xylène ; des solvants aliphatiques tels que l'hexane, l'heptane ou l'octane ; des solvants cétoniques ; et des esters. On préfère les solvants aromatiques.

La composition silicone comprend de préférence de 4 à 9 parties en poids de résine silicone (i) pour une partie en poids d'huile silicone (ii), soit un rapport en poids (i)/(ii) qui varie de 4/1 à 9/1.

Le procédé de préparation va maintenant être décrit plus précisément, notamment en ce qui concerne le cycle thermique envisagé. Tout d'abord, comme cela a été indiqué, on dépose une couche de la composition silicone filmogène sur la surface d'un support, par exemple une galette de silice. La technique de dépôt est connue en soi : il s'agit du spin-coating.

Puis, on élimine le solvant (iii). Le plus simple consiste à chauffer le dépôt de composition silicone, ce qui permet de faire évaporer le solvant à chaud. Avantageusement, cette étape d'élimination du solvant (iii) est réalisée sous vide, de préférence à une température Tb ("baking") supérieure à la température d'évaporation du solvant et éventuellement inférieure à la température de dégradation de l'huile silicone (ii). Au cours de cette étape d'élimination du solvant, qui peut être considérée comme un séchage, on peut observer une démixtion de phases entre la résine silicone (i) et l'huile silicone (ii), parallèlement à la gélification de la composition. La température Tb dépend de la température d'évaporation du solvant (ii). Sa valeur varie généralement de 100°C à 160°C.

Au cours de l'étape suivante, on réalise un traitement à haute température ("curing") de la couche de composition silicone, d'une part, afin d'éliminer les traces de solvants, et d'autre part, afin de réaliser la cuisson de la composition silicone filmogène. Au cours de cette cuisson, la résine silicone se condense par élimination des groupements - OH et/ou -$OR^1$ résiduels. En outre, l'huile silicone (ii) subit une réversion thermique : elle se dégrade sous forme de composés cycliques de type cyclodialkylsiloxanes, comportant de 3 à 10 motifs dialkylsiloxyles. Ces motifs s'évaporent généralement dès 160°C. Etant donné que la composition a subi une gélification au cours de l'étape précédente de baking et grâce à la réticulation de la couche de composition silicone, la volatilisation des composés cycliques laisse place à un ensemble de pores répartis dans l'épaisseur de la composition réticulée.

Avantageusement, la cuisson de la composition silicone filmogène est réalisée en chauffant à une température Tc supérieure à la température de dégradation de l'huile silicone (ii). La température Tc est supérieure ou égale à 300°C, et de préférence supérieure ou égale à 350°C. Elle est inférieure à la température de dégradation thermique du support et de la résine silicone, soit une température Tc inférieure ou égale à 500°C, et de préférence inférieure ou égale à 400°C.

Selon une autre variante du procédé de préparation, les deux étapes précédemment évoquées (baking et curing) sont réalisées simultanément en chauffant directement la composition silicone filmogène déposée à la surface du support, à une température Tc supérieure à la température de dégradation de l'huile silicone (ii) et à la température d'évaporation du solvant (iii). Ce traitement "flash" est très rapide et permet d'obtenir une porosité beaucoup plus fine.

Dans les deux variantes décrite ci-dessus, le ou les chauffages sont réalisés de préférence à l'aide d'un rayonnement électromagnétique, par exemple, par un rayonnement haute fréquence ou un rayonnement micro-ondes. Les procédés de chauffage de ce type sont bien connus industriellement et trouvent leur intérêt en ce qu'ils permettent un transfert d'énergie directe, avec une densité de puissance en volume élevée.

Selon un deuxième aspect, l'invention concerne un revêtement silicone susceptible d'être obtenu par la mise en oeuvre d'un procédé conforme à l'invention. Comme le montrent les exemples illustrant l'invention, de tels revêtements silicones possèdent une constante diélectrique relative K inférieure ou égale à 3,00. De préférence, K est inférieur ou égal à 2,85, et mieux encore, inférieur ou égal à 2,65. Ainsi, de tels matériaux sont particulièrement intéressants comme matériau d'interconnexion pour la fabrication de circuits intégrés.

En outre, il est tout à fait possible de réaliser, en utilisant une composition silicone telle que décrite ci-dessus, des revêtements dont l'épaisseur est inférieure ou égale à 3200 nm, de préférence, inférieure ou égale à 2000 nm, à 500 nm, voire à 150 nm.

Selon une autre caractéristique de l'invention, un revêtement silicone obtenu par la mise en oeuvre d'un procédé conforme à l'invention, comprend des pores dont le diamètre médian est de l'ordre de 250 nm, de préférence inférieur à 250 nm. Mieux encore, le diamètre médian des pores est compris de 50 nm à 180 nm.

L'invention concerne également un circuit intégré comprenant un revêtement silicone tel que décrit ci-dessus comme isolant électrique. La fabrication des circuits intégrés est largement documentée. Pour n'en citer qu'une, la technique de lithographie optique est particulièrement adaptée.

## EXEMPLES

Le procédé de préparation conforme à l'invention et les revêtements silicones ainsi obtenus vont être illustré par les exemples qui suivent, sans en limiter la portée.

***Dépôt par technique de spin-coating***

Les plaques de verre qui constituent les supports des dépôts (lamelles couvre objet 24x32 mm) sont au préalable dégraissées à l'acétone et au méthanol. Il est ensuite nécessaire de les métalliser (temps de métallisation : 6 min.) pour permettre la mesure ultérieure de la capacitance K du revêtement final. Pour être adaptées au fonctionnement du spin coater (tournette), les lames de verre sont collées sur des disques métalliques de 50 mm de diamètre, le contact électrique entre surfaces conductrices et isolantes étant assuré par un très fin dépôt de laque d'argent.
Quelques gouttes de la composition silicone sont déposées sur la lamelle, positionnée sur son disque à l'intérieur de la tournette. Le spin coater est progressivement lancé à une vitesse de 2000 tours/min pendant 20 sec, puis passe à une vitesse constante de 5000 tours/min pendant 30 sec. Dix échantillons sont ainsi réalisés en moyenne, afin de pouvoir accéder à une statistique de caractérisation et de mesure suffisamment exploitable et fiable (écart de ± 0.10 observé sur la valeur mesurée de la constante diélectrique)

***Détermination de l'épaisseur moyenne des revêtements***

La technique de microscopie à balayage autorise l'accès à la mesure de l'épaisseur du revêtement, moyennant une préparation adaptée de l'échantillon étudié (incision de la lame de verre, rupture puis observation sur la tranche).

***Evaluation de la capacitance et de la constante diélectrique des revêtements***

On mesure la capacitance du revêtement via l'utilisation d'une cellule de mesure diélectrique Agilent 16451B, dont l'électrode de référence utilisée a un diamètre de 5 mm. Ces mesures sont réalisées sous un balayage en fréquence de 50 Hz à 1 MHz (1 MHz étant la spécification affichée sur le cahier des charges des fabricants de matériaux pour l'interconnexion). Si l'épaisseur du revêtement est connue, la constante diélectrique (K) se déduit très facilement de la valeur de la capacitance du dépôt :

$$K = \frac{e \cdot C}{\varepsilon_0 \cdot A}$$

où : e = épaisseur revêtement (m)
C = capacitance (Farad)
A = aire électrode (m2)
$\varepsilon_0$ = permittivité de l'air, $\varepsilon_0$ = 8.854 10-12 Farad/m)
Par convention, dans les exemples, lorsque l'on ne précise par la nature d'un ou des groupes R des motifs M, D et T, alors les groupes R dont on n'a pas précisé la nature sont des groupes méthyles.

***A/ Résines déposées telles quelles ne donnant pas lieu à de la porosité interne (Contre exemples)***

Les compositions silicones selon les exemples 1 et 2 ne contiennent pas d'huile silicone (ii). On n'observe pas le développement d'une porosité au sein des films obtenus à partir de ces compositions silicones.

Exemple 1 :

Une résine silicone de formule $(D^{Phe2})_{10}(D)_{30.}(T^{Phe})_{57}(T)_3$ est préalablement diluée à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.
L'ensemble des dépôts est ensuite séché en étuve sous vide à 120°C pendant 1 heure. Un balayage d'azote à la fin du cycle de tirage sous vide réseau peu poussé, de l'ordre d'une dizaine de mm Hg, permet de s'affranchir de la présence de toute trace d'oxygène. L'ensemble des dépôts est enfin placé dans un four et cuit à 350°C pendant 1 heure sous balayage constant d'azote.
Les films résultants ont une épaisseur comprise entre 140 et 480 nm. La constante diélectrique moyenne de ces films, mesurée à 1 MHz, est de 2,80 (± 0,10).

Exemple 2 :

Une résine silicone de formule $(T)_{34}(D^{Phe})_{31}(T^{Phe})_{35}$ est préalablement diluée à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.
L'ensemble des dépôts est ensuite séché en étuve sous vide à 120°C pendant 1 heure. Un balayage d'azote à la fin du cycle de tirage sous vide réseau permet de s'affranchir de la présence de toute trace d'oxygène. L'ensemble des dépôts est enfin placé dans un four et cuit à 350°C pendant 1 heure sous balayage constant d'azote.
Les films résultants ont une épaisseur comprise entre 580 et 1800 nm. La constante diélectrique moyenne de ces films, mesurée à 1 MHz, est de 2,85 ($\pm$ 0,10).

***B/ Mélanges résine silicone et huile silicone hydroxylée (Exemples selon l'invention)***

Les exemples 3 à 6 permettent de comparer deux traitements : traitement en deux étapes baking suivi de curing, ou traitement en une seule étape flash, ainsi que deux ratio résine/huile dans la composition silicone.

Exemple 3 : Traitement en deux étapes "baking" et "curing"

Un mélange constitué d'une résine silicone de formule $(T)_{34}(D^{Phe})_{31}(T^{Phe})_{35}$ et d'une huile silicone $\alpha,\omega$-dihydroxylée de formule $(M^{OH})(D)_{4,5}(M^{OH})$, de rapport en poids résine/huile 80/20, est préalablement dilué à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.
L'ensemble des dépôts est ensuite séché en étuve sous vide à 120°C pendant 1 heure. Un balayage d'azote à la fin du cycle de tirage sous vide réseau permet de s'affranchir de la présence de toute trace d'oxygène. L'ensemble des dépôts est enfin placé dans un four et cuit à 350°C pendant 1 heure sous balayage constant d'azote.
Les films résultants ont une épaisseur comprise entre 350 et 780 nm et une porosité interne fermée dont le diamètre moyen est de l'ordre de 250 nm. La constante diélectrique moyenne de ces films, mesurée à 1 MHz, est de 2,38 ($\pm$ 0,10).

Exemple 4 : Traitement "flash"

Un mélange constitué d'une résine silicone de formule $(T)_{34}(D^{Phe})_{31}(T^{Phe})_{35}$ et d'une huile silicone $\alpha,\omega$-dihydroxylée de formule $(M^{OH})(D)_{4,5}(M^{OH})$, de rapport en poids résine/huile 80/20, est préalablement dilué à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.
L'ensemble des dépôts est directement placé dans un four et cuit à 350°C pendant 1 heure sous balayage constant d'azote.
Les films résultants ont une épaisseur comprise entre 350 et 780 nm et une porosité interne fermée dont le diamètre moyen est de l'ordre de 100 nm. La constante diélectrique moyenne de ces films, mesurée à 1 MHz, est de 2,42 ($\pm$ 0,10).

Exemple 5 : Traitement en deux étapes "baking" et "curing"

Un mélange constitué d'une résine silicone de formule $(T)_{34}(D^{Phe})_{31}(T^{Phe})_{35}$ et d'une huile silicone $\alpha,\omega$-dihydroxylée de formule $(M^{OH})(D)_{4,5}(M^{OH})$, de rapport en poids résine/huile 90/10, est préalablement dilué à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.

L'ensemble des dépôts est ensuite séché en étuve sous vide à 120°C pendant 1 heure. Un balayage d'azote à la fin du cycle de tirage sous vide réseau permet de s'affranchir de la présence de toute trace d'oxygène. L'ensemble des dépôts est enfin positionné dans un four et cuit à 350°C pendant 1 heure sous balayage constant d'azote.

Les films résultants ont une épaisseur comprise entre 300 et 800 nm et une porosité interne fermée dont le diamètre moyen est de l'ordre de 180 nm. La constante diélectrique moyenne de ces films, mesurée à 1 MHz, est de 2,65 ($\pm$ 0,10).

<u>Exemple 6 : Traitement "flash"</u>

Un mélange constitué d'une résine silicone de formule $(T)_{34}(D^{Phe})_{31}(T^{Phe})_{35}$ et d'une huile silicone $\alpha,\omega$-dihydroxylée de formule $(M^{OH})(D)_{4,5}(M^{OH})$, de rapport en poids résine/huile 90/10, est préalablement dilué à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.

L'ensemble des dépôts est directement positionné dans un four et cuit à 350°C pendant 1 heure sous balayage constant d'azote.

Les films résultants ont une épaisseur comprise entre 300 et 800 nm et une porosité interne fermée dont le diamètre moyen est de l'ordre de 50 nm La constante diélectrique moyenne de ces films, mesurée à 1 MHz, est de 2,60 ($\pm$ 0,10).

***C/ Mélanges résine silicone et huile silicone non hydroxylée (Contre-exemples)***

Les exemples 7 et 8 démontrent l'importance du choix de l'huile silicone parmi les huiles silicones hydroxylées.

<u>Exemple 7 :</u>

Un mélange constitué d'une résine silicone de formule $(T)_{34}(D^{Phe})_{31}(T^{Phe})_{35}$ et d'une huile silicone à terminaisons triméthyles de formule $(M)(D)_4(M)$, de rapport en poids 90/10, est préalablement dilué à 20% en poids dans du toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.

L'ensemble des dépôts est ensuite séché en étuve sous vide à 120°C pendant 1 heure. Un balayage d'azote à la fin du cycle de tirage sous vide réseau permet de s'affranchir de la présence de toute trace d'oxygène. L'ensemble des dépôts est enfin placé dans un four et cuit à 350°C pendant 1 heure sous balayage constant d'azote.

Les films résultants ont une épaisseur comprise entre 350 et 750 nm mais ne présentent pas de porosité interne.

<u>Exemple 8 :</u>

Un mélange constitué d'une résine silicone de formule $(T)_{34}(D^{Phe})_{31}(T^{Phe})_{35}$ et d'une huile silicone à terminaisons triméthyles de formule $(M)(D)_4(M)$, de rapport en poids 90/10, est préalablement dilué à 20% en poids dans du Toluène. Quelques gouttes de la solution sont déposées sur une lamelle de verre, elle-même collée sur un disque métallique de 50 mm de diamètre, le tout étant positionné sur la tournette d'un appareillage de spin coating. Le spin coater est progressivement lancé à une vitesse de 2000 tours/min pendant 20 sec, puis conserve une vitesse constante de 5000 tours/min pendant 30 sec. Dix dépôts de la même solution sont consécutivement réalisés selon le protocole décrit.

L'ensemble des dépôts est directement placé dans un four et cuit à 350°C pendant 1 heure sous balayage constant d'azote.

Les films résultants ont une épaisseur comprise entre 350 et 750 nm mais ne présentent pas de porosité interne.

***Conclusion***

Les exemples précédents démontrent que toutes choses étant égales par ailleurs, la diminution de la quantité d'huile silicone dans le mélange de départ permet de diminuer de façon importante la taille des pores dans le revêtement.

En outre, l'application d'un "flash" thermique au dépôt, plutôt que la préparation du dépôt en deux étapes de chauffage successives (baking puis curing), permet également de réduire la dimension des pores.

Par ailleurs, l'absence d'huile silicone dans la composition ou l'intégration d'huile silicone linéaire non hydroxylée

dans la composition, conduit à des revêtements non poreux, indépendamment du protocole de préparation (en deux étapes ou "flash").

## Revendications

**1.** Procédé de préparation d'un revêtement silicone à faible constante diélectrique, comprenant les étapes essentielles suivantes :

a) on dépose une composition silicone filmogène sur la surface d'un support, ladite composition silicone comprenant : (i) au moins une résine silicone filmogène réticulable, (ii) au moins une huile silicone essentiellement linéaire, α,ω-hydroxylée, susceptible de se dégrader à chaud, et (iii) au moins un solvant apte à compatibiliser la résine silicone (i) et l'huile silicone (ii),
b) on élimine le solvant (iii), de préférence par chauffage et, de façon simultanée ou séquentielle,
c) on chauffe pour réaliser la cuisson de la composition silicone filmogène.

**2.** Procédé selon la revendication 1, dans lequel on élimine le solvant (iii) par évaptiration, en chauffant la composition silicone, de préférence sous vide, à une température Tb supérieure à la température d'évaporation du solvant (iii) et inférieure à la température de dégradation de l'huile silicone (ii).

**3.** Procédé selon la revendication 1 ou 2, dans lequel on réalise la cuisson de la composition silicone filmogène en chauffant à une température Tc supérieure à la température de dégradation de l'huile silicone (ii).

**4.** Procédé selon la revendication 1, dans lequel on élimine le solvant (iii) par évaporation, en chauffant la composition silicone, de préférence sous vide, et on réalise la cuisson de la composition silicone filmogène en chauffant à une température Tc supérieure à la température de dégradation de l'huile silicone (ii) et à la température d'évaporation du solvant (iii).

**5.** Procédé selon la revendication 2 ou 3, dans lequel la température Tb est comprise de 100°C à 160°C, de préférence de l'ordre de 120°C.

**6.** Procédé selon la revendication 3 ou 4, dans lequel la température Tc est supérieure ou égale à 300°C, de préférence supérieure ou égale à 350°C, et inférieure à la température de dégradation thermique du support et de la composition silicone.

**7.** Procédé selon la revendication 6, dans lequel la température Tc est inférieure ou égale à 500°C, de préférence inférieure ou égale à 400°C.

**8.** Procédé selon l'une quelconque des revendications précédentes, dans lequel au moins une étape de chauffage est réalisée à l'aide d'un rayonnement électromagnétique, de préférence par rayonnement haute fréquence ou micro-onde.

**9.** Procédé selon l'une quelconque des revendications précédentes, dans lequel la résine silicone (i) présente par molécule :

- d'une part au moins deux motifs siloxyles différents choisis parmi les motifs M, D, T et/ou Q, l'un au moins de ces motifs étant un motif T ou Q, de formules :

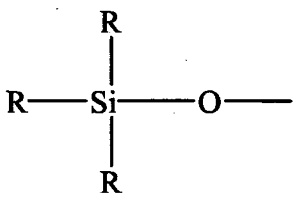

$M = (R)_3SiO_{1/2}$

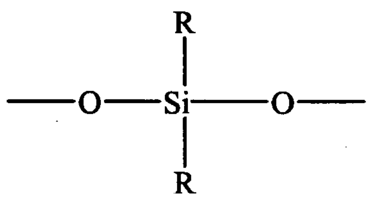

$D = (R)_2SiO_{2/2}$

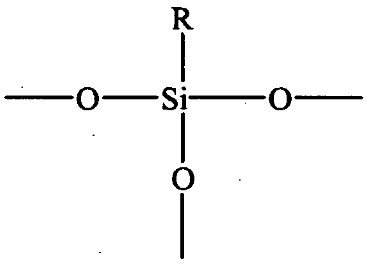

$T = (R)SiO_{3/2}$

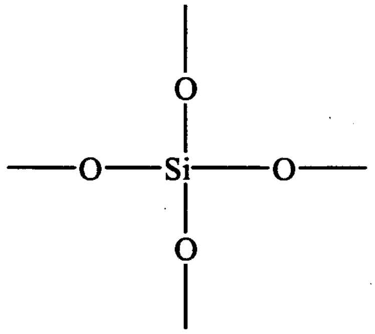

$Q = SiO_{4/2}$

- et d'autre part, au moins trois groupements hydrolysables/condensables -OH et/ou $-OR^1$,
où les radicaux R sont identiques ou différents les uns des autres et représentent un groupe alkyle linéaire ou ramifié en C1 à C6, un groupe alkényle linéaire ou ramifié en C2 à C4, un groupe aryle en C6 à C10, ou un groupe aralkyle C6 à C10, les radicaux R étant éventuellement halogénés, et au moins l'un des radicaux R représente un groupe aryle ou aralkyle,
et où les radicaux $R^1$ sont identiques ou différents les uns des autres et représentent un groupe alkyle linéaire ou ramifié en C1 à C6.

**10.** Procédé selon la revendication précédente, dans lequel la résine silicone (i) comporte jusqu'à 2% en poids de groupes hydroxyles.

**11.** Procédé selon la revendication 9 ou 10, dans lequel la résine silicone (i) comporte au moins deux des motifs $D^{Phe}$, T et $T^{Phe}$.

**12.** Procédé selon l'une quelconque des revendications précédentes, dans lequel l'huile silicone (ii), est une huile polydiorganosiloxane essentiellement linéaire à extrémités hydroxylées, de préférence polydiméthylsiloxane linéaire à extrémités hydroxylées.

**13.** Procédé selon l'une quelconque des revendications précédentes, dans lequel le rapport en poids i/ii entre la résine silicone (i) et l'huile silicone (ii) varie entre 4/1 et 9/1.

**14.** Procédé selon l'une quelconque des revendications précédentes, dans lequel le solvant (iii) est un solvant organique, de préférence sélectionné parmi les solvants aromatiques, les solvant aliphatiques, les solvants cétoniques, les esters et leurs mélanges.

**15.** Revêtement silicone susceptible d'être obtenu à l'issue d'un procédé selon l'une quelconque des revendications précédentes.

**16.** Revêtement silicone selon la revendication précédente, présentant une constante diélectrique relative K inférieure ou égale à 3,00, de préférence, inférieure ou égale à 2,85 mieux encore, inférieure ou égale à 2,65.

**17.** Revêtement silicone selon l'une des revendications 15 ou 16, dont l'épaisseur est inférieure ou égale à 3200 nm, de préférence inférieure ou égale à 2000 nm, 500 nm voire 150 nm.

**18.** Revêtement silicone selon l'une quelconque des revendications 15 à 17, comprenant des pores dont la taille médiane est de l'ordre de 250 nm, de préférence inférieure à 250 nm, et mieux encore, comprise de 50 nm à 180 nm.

**19.** Circuit intégré comprenant un revêtement silicone selon l'une quelconque des revendications 15 à 18, comme isolant électrique.

**20.** Utilisation d'une composition silicone comprenant : (i) au moins une résine silicone filmogène réticulable, (ii) au moins une huile silicone essentiellement linéaire $\alpha,\omega$-hydroxylée susceptible de se dégrader à chaud, et (iii) au moins un solvant apte à compatibiliser la résine silicone (i) et l'huile silicone (ii), pour la préparation d'un revêtement à faible constante diélectrique dans un circuit intégré.

## Claims

1. Process for the preparation of a silicone coating of low dielectric constant, comprising the following essential steps:

    a) a film-forming silicone composition is deposited on the surface of a substrate, said silicone composition comprising: (i) at least one crosslinkable film-forming silicone resin, (ii) at least one α,ω-hydroxylated, essentially linear silicone oil capable of degrading under the action of heat, and (iii) at least one solvent capable of rendering the silicone resin (i) compatible with the silicone oil (ii),
    b) the solvent (iii) is removed, preferably by heating, and, simultaneously or sequentially,
    c) the film-forming silicone composition is cured by heating.

2. Process according to claim 1 wherein the solvent (iii) is removed by vaporization, the silicone composition being heated, preferably under vacuum, to a temperature Tb that is above the vaporization point of the solvent (iii) and below the degradation point of the silicone oil (ii).

3. Process according to claim 1 or 2 wherein the film-forming silicone composition is cured by heating to a temperature Tc that is above the degradation point of the silicone oil (ii).

4. Process according to claim 1 wherein the solvent (iii) is removed by vaporization, the silicone composition being heated, preferably under vacuum, and the film-forming silicone composition is cured by heating to a temperature Tc that is above the degradation point of the silicone oil (ii) and the vaporization point of the solvent (iii).

5. Process according to claim 2 or 3 wherein the temperature Tb is between 100°C and 160°C, preferably in the order of 120°C.

6. Process according to claim 3 or 4 wherein the temperature Tc is above or equal to 300°C, preferably above or equal to 350°C, and below the thermal degradation point of the substrate and the silicone composition.

7. Process according to claim 6 wherein the temperature Tc is below or equal to 500°C, preferably below or equal to 400°C.

8. Process according to any one of the preceding claims wherein at least one heating step is carried out by means of electromagnetic radiation, preferably highfrequency or microwave radiation.

9. Process according to any one of the preceding claims wherein the silicone resin (i) has the following per molecule:

    - on the one hand at least two different siloxy units selected from the units M, D, T and/or Q, at least one of these units being a unit T or Q, of the formulae:

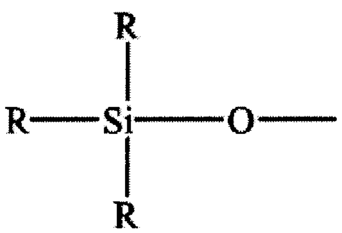

$M = (R)_3SiO_{1/2}$

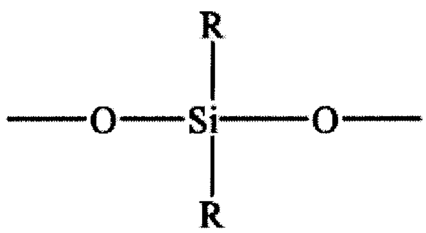

$D = (R)_2SiO_{2/2}$

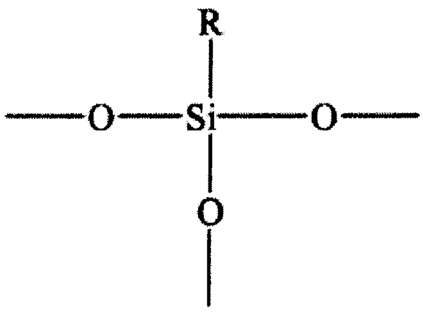

$T = (R)SiO_{3/2}$

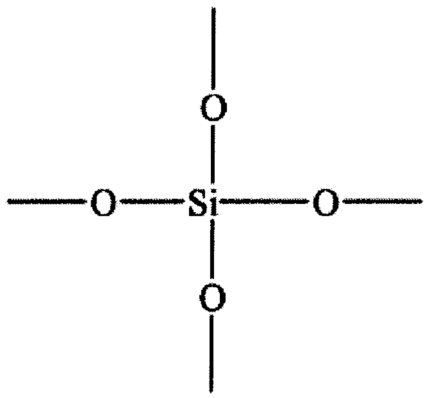

$Q = SiO_{4/2}$

- and on the other hand at least three hydrolyzable/condensable -OH and/or -$OR^1$ groups,

in which the radicals R are identical or different from each other and are a linear or branched C1 to C6 alkyl group, a linear or branched C2 to C4 alkenyl group, a C6 to C10 aryl group or a C6 to C10 aralkyl group, the radicals R optionally being halogenated and at least one of the radicals R being an aryl or aralkyl group,

and in which the radicals $R^1$ are identical or different from each other and are a linear or branched C 1 to C6 alkyl group.

**10.** Process according to the preceding claim wherein the silicone resin (i) contains up to 2% by weight of hydroxyl groups.

**11.** Process according to claim 9 or 10 wherein the silicone resin (i) contains at least two of the units $D^{Phe}$, T and $T^{Phe}$.

**12.** Process according to any one of the preceding claims wherein the silicone oil (ii) is an essentially linear polydiorganosiloxane oil with hydroxylated end groups, preferably linear polydimethylsiloxane with hydroxylated end groups.

**13.** Process according to any one of the preceding claims wherein the weight ratio (i)/(ii) of the silicone resin (i) to the silicone oil (ii) varies between 4/1 and 9/1.

**14.** Process according to any one of the preceding claims wherein the solvent (iii) is an organic solvent preferably selected from aromatic solvents, aliphatic solvents, ketone solvents, esters and mixtures thereof.

**15.** Silicone coating obtainable by a process according to any one of the preceding claims.

**16.** Silicone coating according to the preceding claim which has a relative dielectric constant K that is less than or equal to 3.00, preferably less than or equal to 2.85 and particularly preferably less than or equal to 2.65.

**17.** Silicone coating according to claim 15 or 16 whose thickness is less than or equal to 3200 nm, preferably less than or equal to 2000 nm, 500 nm or even 150 nm.

**18.** Silicone coating according to any one of claims 15 to 17 which comprises pores with a median size in the order of 250 nm, preferably below 250 nm and particularly preferably of between 50 nm and 180 nm.

**19.** Integrated circuit comprising a silicone coating according to any one of claims 15 to 18 as an electrical insulator.

**20.** Use of a silicone composition comprising: (i) at least one crosslinkable film-forming silicone resin, (ii) at least one $\alpha,\omega$-hydroxylated, essentially linear silicone oil capable of degrading under the action of heat, and (iii) at least one solvent capable of rendering the silicone resin (i) compatible with the silicone oil (ii), for the preparation of a coating of low dielectric constant in an integrated circuit.

## Patentansprüche

1. Herstellungsverfahren für die Herstellung einer Silikonbeschichtung mit niedriger Dielektrizitätskonstante, welches die folgenden wesentlichen Schritte umfasst:

   a) man scheidet eine filmbildende Silikonzusammensetzung auf der Oberfläche eines Trägers ab, wobei die Silikonzusammensetzung umfasst: (i) mindestens ein netzartiges filmbildendes Silikonharz, (ii) mindestens ein im wesentlichen lineares, $\alpha,\omega$-hydroxyliertes Silikonöl, das anfällig ist für Zersetzung durch Wärme, und (iii) mindestens ein Lösungsmittel, das in der Lage ist mit Silikonharz (i) und Silikonöl (ii) zu kompatibilisieren,
   b) man entfernt das Lösungsmittel (iii), vorzugsweise durch Erwärmen und, gleichzeitig oder nacheinander,
   c) erwärmt man, um das Brennen der filmbildenden Silikonzusammensetzung zu erreichen.

2. Herstellungsverfahren gemäß Anspruch 1, bei dem man das Lösungsmittel (iii) durch Verdampfen entfernt, durch Erwärmen der Silikonzusammensetzung, vorzugsweise unter Vakuum, auf eine Temperatur Tb, die höher ist als die Verdampfungstemperatur des Lösungsmittels (iii) und niedriger als die Zersetzungstemperatur des Silikonöls (ii).

3. Herstellungsverfahren gemäß Anspruch 1 oder 2, wobei man das Brennen der filmbildenden Silikonzusammensetzung **dadurch** realisiert, dass man auf eine Temperatur Tc erwärmt, die höher als die Zersetzungstemperatur des Silikonöls (ii) ist.

4. Herstellungsverfahren gemäß Anspruch 1, wobei man das Lösungsmittel (iii) durch Verdampfen entfernt, durch Erwärmen der Silikonzusammensetzung, vorzugsweise unter Vakuum, und man das Brennen der filmbildenden Silikonzusammensetzung **dadurch** erreicht, dass auf eine Temperatur Tc erwärmt wird, die höher ist als die Zersetzungstemperatur des Silikonöls (ii) und als die Verdampfungstemperatur des Lösungsmittels (iii).

5. Herstellungsverfahren gemäß Anspruch 2 oder 3, wobei die Temperatur Tb zwischen 100°C und 160°C ist, bevorzugt von der Größenordnung 120°C.

6. Herstellungsverfahren gemäß Anspruch 3 oder 4, wobei die Temperatur Tc höher oder gleich 300°C ist, vorzugsweise höher oder gleich 350°C, und niedriger als die thermische Zersetzungstemperatur des Trägers und der Silikonzusammensetzung.

7. Herstellungsverfahren gemäß Anspruch 6, wobei die Temperatur Tc niedriger oder gleich 500°C ist, vorzugsweise niedriger oder gleich 400°C.

8. Herstellungsverfahren gemäß irgendeinem der vorhergehenden Ansprüche, wobei mindestens ein Schritt des Erwärmens mit Hilfe elektromagnetischer Strahlung erreicht wird, vorzugsweise durch Hochfrequenzstrahlung oder Mikrowellenstrahlung.

9. Herstellungsverfahren gemäß irgendeinem der vorhergehenden Ansprüche, wobei das Silikonharz (i) im Molekül enthält:

   - einerseits mindestens zwei unterschiedliche Siloxylmotive, die ausgewählt sind aus den Motiven M, D, T und/oder Q, wobei mindestens eins der Motive ein Motiv T oder Q ist, mit den Formeln:

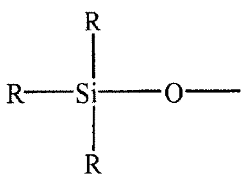

$M = (R)_3SiO_{1/2}$

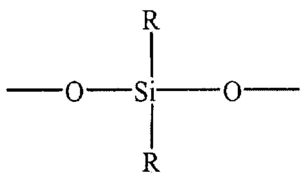

$D = (R)_2SiO_{2/2}$

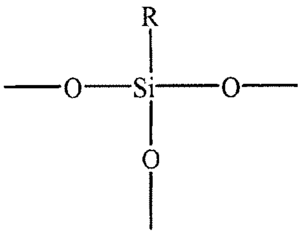

$T = (R)SiO_{3/2}$

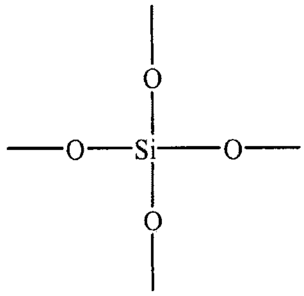

$Q = SiO_{4/2}$

- andererseits mindestens drei hydrolysierbare/kondensierbare -OH und/oder -$OR^1$ Gruppen,

wobei die Reste R gleich oder verschieden zueinander sind und eine lineare oder verzweigte $C_1$-$C_6$-Alkylgruppe, eine lineare oder verzweigte $C_2$-$C_4$-Alkenylgruppe, eine $C_6$-$C_{10}$-Arylgruppe, eine $C_6$-$C_{10}$-Aralkylgruppe darstellen, wobei die Reste R optional halogeniert sind, und wenigstens einer der Reste R eine Arylgruppe oder Aralkylgruppe darstellt,
und wobei die Reste $R^1$ identisch oder verschieden zueinander sind und eine lineare oder verzweigte $C_1$-$C_6$-Alkylgruppe darstellen.

**10.** Herstellungsverfahren gemäß dem vorhergehenden Anspruch, wobei das Silikonharz (i) bis 2 Gew.% Hydroxylgruppen enthält.

**11.** Herstellungsverfahren gemäß Anspruch 9 oder 10, wobei das Silikonharz (i) mindestens zwei der Motive $D^{Phe}$, T und $T^{Phe}$ enthält.

**12.** Herstellungsverfahren gemäß irgendeinem der vorhergehenden Ansprüche, wobei das Silikonöl (ii) ein im wesentlichen lineares an den Enden hydroxyliertes Polydiorganosiloxanöl ist, bevorzugt ein lineares an den Enden hydroxyliertes Polydimethylsiloxan.

**13.** Verfahren gemäß irgendeinem der vorhergehenden Ansprüche, wobei das Gewichtsverhältnis i/ii von dem Silikonharz (i) und dem Silikonöl (ii) zwischen 4/1 und 9/1 variiert.

**14.** Verfahren gemäß irgendeinem der vorhergehenden Ansprüche, wobei das Lösungsmittel (iii) ein organisches Lösungsmittel ist, vorzugsweise ausgewählt aus aromatischen Lösungsmitteln, aliphatischen Lösungsmitteln, ketonischen Lösungsmitteln, Estern und ihren Mischungen.

**15.** Silikonbeschichtung, die durch Durchführung eines Verfahrens gemäß irgendeinem der vorhergehenden Ansprüche erhalten werden kann.

**16.** Silikonbeschichtung gemäß dem vorhergehenden Anspruch, die eine relative Dielektrizitätskonstante K aufweist, die kleiner oder gleich 3,00 ist, vorzugsweise kleiner oder gleich 2,85, besonders bevorzugt kleiner oder gleich 2,65.

**17.** Silikonbeschichtung gemäß einem der Ansprüche 15 oder 16, deren Dicke kleiner oder gleich 3.200 nm ist, bevorzugt kleiner oder gleich 2.000 nm, 500 nm, sogar 150 nm.

**18.** Silikonbeschichtung gemäß irgendeinem der Ansprüche 15 bis 17, die Poren enthält, deren Mittelgröße ungefähr 250 nm, bevorzugt kleiner als 250 nm, und besonders bevorzugt zwischen 50 nm und 180 nm ist.

**19.** Integrierte Schaltung, die eine Silikonbeschichtung gemäß irgendeinem der Ansprüche 15 bis 18 als elektrischen Isolator enthält.

**20.** Verwendung einer Silikonzusammensetzung, die umfasst:

(i) mindestens ein netzartiges filmbildendes Silikonharz, (ii) mindestens ein im wesentlichen lineares, $\alpha,\omega$-

hydroxyliertes Silikonöl, das anfällig ist für Zersetzung durch Wärme, und (iii) mindestens ein Lösungsmittel, das in der Lage ist mit Silikonharz (i) und Silikonöl (ii) zu kompatibilisieren, für die Herstellung einer Beschichtung mit geringer Dielektrizitätskonstante in einer integrierten Schaltung.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 6214748 B
- US 6107357 B
- US 6022814 A
- US 5776990 A
- US 20010010840 A
- US 20030207595 A